Europäisches Patentamt

European Patent Office

Office européen des brevets

(19)

(11) Veröffentlichungsnummer: **0 195 267**
**B1**

(12) **EUROPÄISCHE PATENTSCHRIFT**

(45) Veröffentlichungstag der Patentschrift: 02.05.90

(21) Anmeldenummer: 86102175.6

(22) Anmeldetag: 19.02.86

(51) Int. Cl.⁵: **F 02 D 41/20,** F 02 D 41/22,
H 03 K 17/64

(54) Schaltungsanordnung zur Steuerung des Stromes durch einen elektrischen, insbesondere elektromagnetischen Verbraucher.

(30) Priorität: 20.03.85 DE 3509961

(43) Veröffentlichungstag der Anmeldung:
24.09.86 Patentblatt 86/39

(45) Bekanntmachung des Hinweises auf die
Patenterteilung:
02.05.90 Patentblatt 90/18

(84) Benannte Vertragsstaaten:
DE FR IT SE

(56) Entgegenhaltungen:
EP-A-0 074 536
FR-A-2 458 106
US-A-4 446 410
US-A-4 491 113

PATENT ABSTRACTS OF JAPAN, Band 9, Nr.
142 (M-388)1865r, 18. Juni 1985; & JP-A-60 22
050 (NISSAN JIDOSHA K.K.) 04-02-1985

(73) Patentinhaber: ROBERT BOSCH GMBH
Postfach 50
D-7000 Stuttgart 1 (DE)

(72) Erfinder: Nitschke, Werner, Dipl.-Phys.
Roseggerweg 14
D-7257 Ditzingen (DE)
Erfinder: Taufer, Peter
Talstrasse 45
D-7253 Renningen (DE)

**Beschreibung**

Stand der Technik

Die Erfindung betrifft eine Schaltungsanordnung nach der Gattung des Hauptanspruchs (vergleiche FR—A—2458 106).

Es ist bekannt, eine elektrische Schaltungsanordnung dadurch vor Fehlfunktionen oder gar Zerstörung zu schützen, daß bei einem Kurzschluß des elektrischen Verbrauchers dieser Kurzschluß erkannt und sofort die gesamte Schaltung abgeschaltet wird. Eine Möglichkeit eines solchen Schutzes besteht darin, daß es sich bei dem eingeschalteten Zustand der Schaltung nur um einen labilen Betriebszustand handelt, der im Falle eines Kurzschlusses oder einer sonstigen Fehlfunktion der Schaltung sofort wieder in seinen stabilen Betriebszustand, den ausgeschalteten Zustand der gesamten Schaltung, übergeht. Bei einer derartigen Schaltung wird dabei der elektrische Verbraucher an die Versorgungsspannung angelegt und gegen Masse ein- und ausgeschaltet. Dies hat insbesondere in der Entwicklungs- und Erprobungsphase einer solchen Schaltung den erheblichen Nachteil, daß ungewollte Kurzschlüsse des Verbrauchers gegen Masse zu Fehlfunktionen oder gar Zerstörung führen können. Ebenfalls sind die bekannten Schaltungsanordnungen sehr aufwendig und daher kostspielig.

Aus FR—A—2 458 106 ist weiter eine Schaltungsanordnung bekannt, die den Strom durch einen elektromagnetischen Verbraucher steuert, mit einem Stromsteuerorgan in Serie zum Verbraucher, sowie mit einer Einrichtung, die das Steuerorgan ansteuert, bei der die an dem auf Masse liegenden Verbraucher anliegende Spannung mit einem von der Einrichtung zur Ansteuerung des Steuerorgans abhängigen Spannungsignal verglichen wird und bei der in Abhängigkeit davon der Strom durch den Verbraucher gesteuert wird.

Vorteile der Erfindung

Die Erfindungsgemäße Schaltungsanordnung zur Steuerung des Stromes durch einen elektrischen, insbesondere elektromagnetischen Verbraucher mit den Merkmalen des Hauptanspruchs hat gegenüber dem beschriebenen Stand der Technik den Vorteil, daß mit Hilfe einer einfachen und billigen Schaltung Kurzschlüsse im Zusammenhang mit dem auf Masse liegenden Verbraucher sicher erkannt werden. Dies wird mit den Merkmalen des Anspruchs 1 erreicht.

Zeichnung

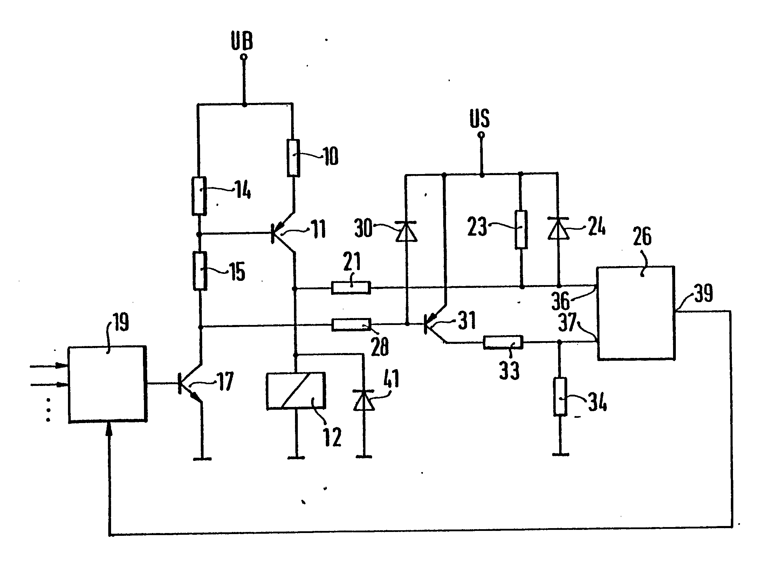

Ein Ausführungsbeispiel der Erfindung ist in der Zeichnung dargestellt und in der nachfolgenden Beschreibung näher erläutert.

Beschreibung des Ausführungsbeispiels

Bei dem erfindungsgemäßen Gegenstand handelt es sich um eine Schaltungsanordnung zur Steuerung des Stromes durch einen elektrischen, insbesondere elektromagnetischen Verbraucher. Bei diesem Verbraucher kann es sich z.B. um ein Magnetventil, um einen Stellmotor, oder ähnliches handeln. Besonders vorteilhaft ist die Verwendung der Schaltungsanordnung in Verbindung mit Brennkraftmaschinen, insbesondere mit der Einspritzung von Kraftstoff in die Brennräume der Brennkraftmaschine und/oder bei der Beeinflussung der Leerlaufdrehzahl der Brennkraftmaschine. Das Ziel der erfindungsgemäßen Schaltungsanordnung ist dabei, Kurzschlüsse des elektrischen Verbrauchers schnell und sicher zu erkennen, um dadurch die gesamte Schaltungsanordnung vor Fehlfunktionen oder gar Zerstörung zu schützen.

Die einzige Figur der Zeichnung zeigt ein Ausführungsbeispiel der erfindungsgemäßen Schaltungsanordnung. Dort bilden ein Meßwiderstand 10, ein Stromsteuerorgan 11, z.B. ein entsprechender Leistungstransistor, und der Verbraucher 12 eine Serienschaltung von einer Batteriespannung UB nach Masse, und zwar in der eben genannten Reihenfolge. Ebenfalls eine Serienschaltung von der Batteriespannung UB nach Masse bilden die beiden Widerstände 14 und 15, sowie der Transistor 17. Dabei ist der Verbindungspunkt der beiden Widerstände 14 und 15 mit der Basis des Transistors 11 verbunden. Die Basis des Transistors 17 hingegen wird von einer Steuerung 19 angesteuert, die ihrerseits abhängig ist von wenigstens einer Eingangsgröße.

Handelt es sich z.B. bei dem elektromagnetischen Verbraucher um ein Einspritzventil für die Zuführung von Kraftstoff in die Brennräume einer Brennkraftmaschine, so kann es sich bei den Eingangsgrößen der Steuerung 19 z.B. um Signale bezüglich der Temperatur der Brennkraftmaschine, der in der Brennkraftmaschine anliegenden Last, usw. handeln. Es ist aber auch möglich, daß der Verbraucher 12 eine andere Verwendung im Zusammenhang mit der Brennkraftmaschine findet, was dann auch andere Eingangsgrößen der Steuerung 19 zur Folge hat.

Vom Verbindungspunkt des Transistors 11 und des Verbrauchers 12 führt ein Widerstand 21 zu einem Eingang 36 eines Vergleicher 26. Dabei ist ebenfalls der Eingang 36 über die Parallelschaltung eines Widerstands 23 und einer Diode 24 mit einer stabilisierten Spannung US verbunden. Weiter ist der Verbindungspunkt des Widerstands 15 und des Transistors 17 mit einem Widerstand 28 verbunden, dessen andere Anschlußpunkt zum einen über eine Diode 30 an die stabilisierte Spannung US, sowie zum anderen an die Basis eines Transistors 31 angeschlossen ist. Die Kollektor-Emitter-Strecke des Transistors 31 führt dabei von der stabilisierten Spannung US zu einem Widerstand 33, dessen zweiter Anschlußpunkt an einem Eingang 37 des Vergleichers 26 anliegt, wobei dieser Eingang 37 ebenfalls über einen Widerstand 34 mit Masse verbunden ist. Der Ausgang des Vergleichers 26 ist mit der Bezugsziffer 39 gekennzeichnet und bildet ein Eingangssignal der Steuerung 19. Die Diode 41 dient schließlich dem Freilauf des Verbrauchers 12.

Wichtig ist bei der erfindungsgemäßen Schaltungsanordnung, daß die Batteriespannung UB größer ist als die stabilisierte Spannung US, so z.B. UB=12 V, US=5 V, und daß der Meßwiderstand 10 klein ist gegenüber dem Widerstand des Verbrauchers 12, sowie gleichzeitig der Widerstand des Verbrauchers 12 klein ist gegenüber den beiden Widerständen 21 und 23.

Insgesamt gibt es vier Betriebszustände der in der Figur dargestellten Schaltungsanordnung, nämlich jeweils der ein- und ausgeschaltete Zustand des Stromsteuerorgans 11 bei intaktem und defektem, d.h. kurzgeschlossenem Verbraucher 12. Ist das Stromsteuerorgan 11 eingeschaltet, fließt also Strom über dieses Stromsteuerorgan 11, so sind auch, unabhängig vom Verbraucher 12, die beiden Transistoren 17 und 31 eingeschaltet. Sperrt hingegen das Stromsteuerorgan 11, fließt also kein Strom, so sind auch die beiden Transistoren 17 und 31 ausgeschaltet, also in ihrem gesperrten Zustand.

Es sei nun der Transistor 17 von der Steuerung 19 in seinen leitenden Zustand geschaltet und der Verbraucher intakt. Dies hat zur Folge, daß der Eingang 36 des Vergleichers 26 auf einem Potential liegt, das größer ist als der Wert der stabilisierten Spannung US, da aufgrund des nicht defekten Verbrauchers 12 und der entsprechenden Wahl der Widerstände 10 und 21 der Verbindungspunkt des Stromsteuerorgans 11 und des Verbrauchers 12 auf einem Potential liegt, dessen Wert ebenfalls größer ist als der Wert der stabilisierten Spannung US. Der Eingang 37 des Vergleichers 26 hingegen liegt aufgrund des über den leitenden Transistors 31 nach der stabilisierten Spannung US geschalteten Spannungsteilers aus den Widerständen 33 und 34 auf einem Potential, das kleiner ist als der Wert der stabilisierten Spannung US. Insgesamt weist also der Eingang 36 des Vergleichers 26 ein höheres Potential auf als der Eingang 37, was zur Folge hat, daß der Ausgang 39 des Vergleichers 26 ein Signal abgibt, das die korrekte Funktionsweise der gesamten Schaltungsanordnung anzeigt.

Es sei nun angenommen, daß die Steuerung 19, den Transistor 17 abgeschaltet hat, der Verbraucher 12 im ersten Fall intakt, im zweiten Fall defekt ist. Der sperrende Transistor 17 hat zur Folge, daß auch der Transistor 31 sperrt, wodurch dann der Eingang 37 des Vergleichers 26 über den Widerstand 34 auf Masse liegt. Der Eingang 36 des Vergleichers 26 hingegen liegt bei abgeschaltetem Transistor 17 in jedem Fall auf einem Potential, das größer ist als 0 Volt, da über die Widerstände 23 und 21 auch bei kurzgeschlossenem Verbraucher 12 ein Spannungsteiler existiert. Damit ist bei abgeschaltetem Stromsteuerorgan 11 in jedem Fall das Potential des Eingangs 36 des Vergleichers 26 größer als das Potential des Eingangs 37, so daß wiederum der Ausgang 39 des Vergleichers 26 die korrekte Funktion der gesamten Schaltungsanordnung anzeigt.

Da die gesamte Schaltungsanordnung das Ziel hat, Kurzschlüsse des Verbrauchers 12 zu erkennen, um dadurch Fehlfunktionen oder gar die Zerstörung der Schaltungsanordnung zu vermeiden, handelt es sich auch bei dem Betriebszustand des ausgeschalteten Stromsteuerorgans 11 bei gleichzeitig defektem, d.h. kurzgeschlossenem Verbraucher 12 um einen korrekten Betriebszustand, da ja die gesamte Schaltungsanordnung ausgeschaltet ist und dadurch eine Zerstörung der Schaltungsanordnung nicht möglich ist. Das gleiche gilt auch für den Betriebsfall, daß der Verbraucher 12 einen elektrischen Leerlauf darstellt, die gesamte Schaltungsanordnung jedoch ausgeschaltet ist. Auch in diesem Betriebsfall zeigt der Ausgang 39 des Vergleichers 26 die korrekte Funktion der Schaltungsanordnung an, da ja auch in diesem Betriebsfall keine Zerstörung der Schaltungsanordnung möglich ist. Wichtig ist, daß in dem Moment, in dem bei einem defekten Verbraucher die Schaltungsanordnung eingeschaltet wird, oder in dem bei eingeschalteter Schaltungsanordnung der Verbraucher defekt wird, sofort dieser fehlerhafte Betriebszustand erkannt und die gesamte Schaltungsanordnung abgeschaltet wird.

Es sei nun als leitzter Betriebszustand angenommen, daß die Steuerung 19 den Transistor 17 in seinen leitenden Zustand geschaltet hat und daß der Verbraucher 12 defekt, d.h. kurzgeschlossen ist. Wie schon ausgeführt wurde, weist bei eingeschaltetem Stromsteuerorgan 11 der Eingang 37 des Vergleichers 26 ein Potential auf, das kleiner ist als die stabilisierte Spannung US, gleichzeitig aber größer ist als 0 Volt. Aufgrund des Kurzschlusses des Verbrauchers 12 liegt nun der Verbindungspunkt des Widerstands 21 und des Stromsteuerorgans 11 auf Masse, so daß dadurch auch der Eingang 36 des Vergleichers 26 kleiner ist als die stabilisierte Spannung US und gleichzeitig größer als 0 Volt. Durch die Dimensionierung der Widerstände 21 und 23, bzw. der Widerstände 33 und 34 ist es nun möglich, daß in dem vorliegenden Betriebszustand jedoch das Potential des Eingangs 36 kleiner ist als das Potential des Eingangs 37. Dadurch unterscheidet sich der vorliegende Betriebszustand von den bisher behandelten Betriebszuständen, so daß jetzt am Ausgang 39 des Vergleichers 26 ein Signal ausgegeben wird, das die fehlerhafte Funktion der gesamten Schaltungsanordnung anzeigt. Mit Hilfe dieses Fehlersignals wird dann durch die Steuerung 19 der Transistor 17 sofort abgeschaltet, wodurch ebenfalls sofort jeglicher Stromfluß über den Meßwiderstand 10 und das Stromsteuerorgan 11 endet. Dadurch ist es insgesamt möglich, die gesamte Schaltungsanordnung und insbesondere den Meßwiderstand 10 und das Stromsteuerorgan 11 aufgrund zu hoher auftretender Ströme vor Zerstörung zu schützen.

Dieselbe Wirkungsweise der beschriebenen Schaltungsanordnung tritt auch dann auf, wenn bei eingeschaltetem Stromsteuerorgan 11 der Verbraucher 12 von seinem intakten zu seinem defekten, d.h. kurzgeschlossenem Zustand übergeht. Auch durch diesen Übergang wird sofort das Fehlersignal am Ausgang 39 des Vergleichers 26 ausgelöst und die gesamte Schaltungsanordnung abgeschaltet. Geht hingegen der Verbraucher 12 nicht in einen kurzgeschlossenen Zustand über, sondern bildet der Verbraucher 12 einen elektrischen Leerlauf, so wird dies von der beschriebenen Schaltungsanordnung, wie schon ausgeführt wurde, als korrekte Funktion betrachtet, da in diesem Betriebszustand auch bei leitendem Stromsteuerorgan 11 nur ein geringer Strom über den Meßwiderstand 10 und das Stromsteuerorgan 11 fließt, der keine Gefährdung für diese Bauelemente oder die restliche Schaltungsanordnung darstellt.

Zusammengefaßt ergibt sich also, daß die beschriebene Schaltungsanordnung nur dann den Strom über das Stromsteuerorgan 11 abschaltet, wenn aufgrund eines Kurzschlusses des Verbrauchers 12 die gesamte Schaltungsanordnung vor ihrer Zerstörung geschützt werden muß. In allen anderen Betriebszuständen, auch wenn der Verbraucher 12 defekt ist, wird die Schaltungsanordnung jedoch nicht abgeschaltet, da sämtliche andere Betriebszustände keine Gefährdung der Schaltungsanordnung darstellen.

Die beschriebene und dargestellte Schaltungsanordnung stellt ein Beispiel einer möglichen Ausführung der Erfindung dar. Es ist z.B. möglich, die Diode 30 unter bestimmten Voraussetzungen ersatzlos zu streichen, oder es ist möglich, den Vergleicher 26 in der Form eines einfachen Komparators auszuführen. Auch für die Steuerung 19 gibt es verschiedene Möglichkeiten der Ausführung, die jedoch bekannt und nicht Gegenstand dieser Erfindung sind.

**Patentansprüche**

1. Schaltungsanordnung zur Steuerung des Stromes durch einen elektrischen, insbesondere elektromagnetischen Verbraucher (12), mit einem Stromsteuerorgan (11) in Serie zum Verbraucher (12), sowie mit einer Einrichtung (18) zur Ansteuerung des Stromsteuerorgans (11), bei der die an dem auf Masse liegenden Verbraucher (12) anliegende Spannung in einem Vergleicher (26) mit einem von der Einrichtung (13) zur Ansteuerung des Stromsteuerorgans abhängigen Signal verglichen und in Abhängigkeit von dem Vergleichsergebnis der Strom durch den Verbraucher (12) gesteuert wird, dadurch gekennzeichnet, daß die Parallelschaltung eines Widerstands (23) und einer Diode (24) mit einem weiteren Widerstand (21) und dem Verbraucher (12) eine an einer zweiten Spannung (US) liegende erste Serienschaltung bildet, die an einem Abgriff mit einem ersten Eingang (36) des Vergleichers (26) verbunden ist, daß eine aus Stromsteuerorgan (11), Verbraucher (12) und einem Meßwiderstand (10) bestehende, an einer ersten Spannung (UB) liegende, zweite Serienschaltung vorgesehen ist, daß weiter eine ebenfalls an der zweiten Spannung (US) liegende Serienschaltung von Widerständen (33, 34) vorgesehen ist, deren Abgriff mit dem zweiten Eingang (37) des Vergleichers (26) verbunden ist, wobei die erste Spannung (UB) größer ist als die zweite Spannung (US), wobei der Widerstandswert des Meßwiderstands (10) klein ist gegenüber dem Widerstandswert des Verbrauchers (12), dessen Widerstandswert seinerseits kleiner ist im Vergleich zu den Widerstandswerten der beiden Widerstände (21 und 23), wobei weiter die Widerstandswerte der Widerstände (21, 23 bzw. 33, 34) so gewählt sind, daß bei kurzgeschlossenem Verbraucher (12) das Potential des ersten Eingangs (36) des Vergleichers größer ist als dasjenige des zweiten Eingangs (37).

2. Schaltungsanordnung nach wenigstens einem der Ansprüche 1 bis 6, dadurch gekennzeichnet, daß es sich bei dem Verbraucher um eine elektromagnetische Einrichtung einer Brennkraftmaschine handelt, insbesondere um ein Einspritzventil für die Zuführung von Kraftstoff zum Brennraum einer Brennkraftmaschine.

3. Schaltungsanordnung nach wenigstens einem der Ansprüche 1 bis 7, dadurch gekennzeichnet, daß es sich bei dem elektromagnetischen Verbraucher um ein Ventil handelt, mit dessen Hilfe die Leerlaufdrehzahl der Brennkraftmaschine beeinflußt wird.

**Revendications**

1. Circuit de commande du courant dans un consommateur électrique (12), en particulier électromagnétique, comportant un organe de commande du courant (11) branché en série par rapport au consommateur (12), ainsi qu'un dispositif (19) destiné à l'attaque de l'organe de commande du courant (11), dans lequel la tension existant dans le consommateur (12) relié à la masse est comparée dans un comparateur (26) à un signal dépendant du dispositif (13) destiné à l'attaque de l'organe de commande du courant, et le courant passant dans le consommateur (12) étant commandé en fonction du résultat de comparaison, caractérisé en ce que le montage en parallèle d'une résistance (23) et d'une diode (24) avec une résistance supplémentaire (21) et le consommateur (12) constitue un premier circuit série se trouvant sur une deuxième tension (US), circuit relié à une prise à l'aide d'une première entrée (36) du comparateur (26), en ce qu'il est prévu un deuxième circuit en série, se composant d'un organe de commande du courant (11), d'un consommateur (12) et d'une résistance de mesure (10), et se trouvant sur une première tension (UB), en ce qu'il est prévu un circuit série de résistances (33, 34), se trouvant également sur la deuxième tension (US), circuit dont une prise est reliée avec la deuxième entrée (37) du comparateur (26), la première tension (UB) étant supérieure à la deuxième tension (US), la valeur de la résistance de mesure (10) étant petite par rapport à la valeur de résistance du consommateur (12) dont la valeur de résistance est de son côté petite en comparaison des valeurs des deux résistances (21 et 23), les valeurs des résistances (21, 23 ou 33, 34) étant en outre choisies de façon que, lorsque le consommateur (12) est placé en court-circuit, le potentiel de la première entrée (36) du comparateur est plus élevé que celui de la deuxième entrée (37).

2. Circuit de commande selon au moins une des revendications 1 à 6, caractérisé en ce qu'il s'agit pour le consommateur d'un dispositif électromagnétique d'un moteur à combustion interne, en particulier d'une soupape d'injection pour l'alimentation en carburant dans la chambre de combustion d'un moteur à combustion interne.

3. Circuit de commande selon au moins une des revendications 1 à 7, caractérisé en ce qu'il s'agit pour le consommateur électromagnétique d'une soupape, à l'aide de laquelle la vitesse de rotation de ralenti du moteur à combustion interne est influencée.

**Claims**

1. Circuit arrangement for controlling the current through an electric, particularly electromagnetic, load (12), with a current control element (11) in series with the load (12), and with a device (13) for driving the current control element (11), in which device the voltage across the load (12) connected to earth is compared in a comparator (26) with a signal which depends on the device (13) for driving the current control element and the current through the load (12) is controlled in dependence on the result of the comparison, characterized in that the parallel circuit of a resistor (23) and a diode (24) forms with a further resistor (21) and the load (12) a first series circuit which is connected to a second voltage (US) and which is connected at a tap to a first input (36) of the comparator (26), that a second series circuit consisting of current control element (11), load (12) and a sensing resistor (10) and connected to a first voltage (UB) is provided, that furthermore a series circuit of resistors (33, 34), which is also connected to the second voltage (US), is provided, the tap of which is connected to the second input (37) of the comparator (26), the first voltage (UB) being greater than the second voltage (US), the resistance value of the sensing resistor (10) being small compared with the resistance value of the load (12), the resistance value of which, in turn, is smaller in comparison with the resistance values of the two resistors (21 and 23), the resistance values of the resistors (21, 23 and 33, 34) furthermore being selected in such a manner that the potential of the first input (36) of the comparator is greater than that of the second input (37) when the load (12) is short circuited.

2. Circuit arrangement according to at least one of Claims 1 to 6 (sic), characterized in that the load is an electromagnetic device of an internal combustion engine, particularly an injection valve for supplying fuel to the combustion space of an internal combustion engine.

3. Circuit arrangement according to at least one of Claims 1 to 7 (sic), characterized in that the electromagnetic load is a valve with the aid of which the idling speed of the internal combustion engine is influenced.

EP 0 195 267 B1